# EUROPÄISCHE PATENTSCHRIFT

(11) **EP 3 200 292 B1**
(45) Veröffentlichungstag und Bekanntmachung des Hinweises auf die Patenterteilung: **22.08.2018**
(21) Anmeldenummer: 16153412.8
(22) Anmeldetag: 29.01.2016
(51) Int. Cl.: H02B 1/052

(54) **VORRICHTUNG ZUR BEFESTIGUNG EINES KOMMUNIKATIONS- UND/ODER AUTOMATISIERUNGSGERÄTS AN EINER HUTSCHIENE UND KOMMUNIKATIONS- UND/ODER AUTOMATISIERUNGSGERÄT**
DEVICE FOR FIXING A COMMUNICATION AND/OR AUTOMATION DEVICE ON A TOP-HAT RAIL AND COMMUNICATION AND/OR AUTOMATION DEVICE
DISPOSITIF DE FIXATION D'UN APPAREIL D'AUTOMATISATION ET/OU DE COMMUNICATION SUR UN RAIL NORMALISE ET APPAREIL D'AUTOMATISATION ET/OU DE COMMUNICATION

(43) Veröffentlichungstag der Anmeldung: 02.08.2017
(73) Patentinhaber: Siemens Aktiengesellschaft, 80333 München (DE)
(72) Erfinder: Schweizer, Urs, 76316 Malsch-Waldprechtsweier (DE)

(56) Entgegenhaltungen:
- DE-A1- 3 922 551
- FR-A1- 2 727 804

## Beschreibung

Industrielle Automatisierungssysteme, die eine Vielzahl an Kommunikations- und Automatisierungsgeräten umfassen, dienen zur Überwachung, Steuerung und Regelung von technischen Prozessen, insbesondere im Bereich Fertigungs-, Prozess- und Gebäudeautomatisierung. Zu Kommunikations- und Automatisierungsgeräten zählen beispielsweise speicherprogrammierbare Steuerung, dezentrale Peripheriemodule, Schütze, Kommunikationsmodule, Switches und Router. Darüber hinaus ermöglichen industrielle Automatisierungssysteme einen Betrieb von Steuerungseinrichtungen, Sensoren, Maschinen und industriellen Anlagen, der möglichst selbständig und unabhängig von menschlichen Eingriffen erfolgen soll. Aufgrund einer ständig steigenden Bedeutung von Informationstechnik für Automatisierungssysteme, die zahlreiche vernetzte Steuerungs- bzw. Rechnereinheiten umfassen, gewinnen Verfahren zur zuverlässigen Bereitstellung von über ein Automatisierungssystem verteilten Funktionen für eine Bereitstellung von Überwachungs-, Steuerungs- und Regelungsfunktionen verstärkt an Bedeutung.

Häufig werden Kommunikations- bzw. Automatisierungsgeräte und elektrische Betriebsmitteln, wie Relais, Stromstoßschalter, Zeitschaltuhren, Sicherungsautomaten und Reihenklemmen, auf Hutschienen befestigt, insbesondere in Verteilerkästen, Schaltschränken oder Anschlusskästen. Eine Hutschiene basiert üblicherweise auf einer Profilschiene aus Metall, auf die zu befestigende Geräte seitlich aufgeschoben oder von vorne aufgesteckt und arretiert werden können. Zahlreiche Hutschienentypen sind beispielsweise entsprechend DIN EN 60715 genormt.

Aus DE 197 09 815 A1 ist ein an einer Tragschiene befestigbares Gerät bekannt, das an seiner Gerätebasis einen durch eine Rückstellfeder belasteten Halteschieber aufweist, der zwischen einer Haltestellung und einer Freistellung bewegbar ist. Mehrere derartige Geräte können an einer Tragschiene aneinander gereiht werden. Darüber hinaus steht zumindest ein Halteschieber in Eingriff mit einem von einer Geräteoberseite bedienbaren Lösehebel. Dieser Lösehebel weist einen Wirkarm mit einer Kraftkomponente in einer Arbeitsebene des Halteschiebers in Löserichtung auf.

In EP 2 677 846 A1 ist ein auf einer Hutschiene befestigbares Gerät beschrieben, das ein Gehäuse, eine Gehäusenut zur Aufnahme einer Hutschiene, eine Gehäuseaussparung zur Aufnahme eines Schiebers und einen federbelasteten Schieber als Befestigungselement aufweist. Der Schieber ist eine Verriegelungsposition, in der ein Eingriffsabschnitt des Schiebers aus der Gehäuseaussparung in die Gehäusenut hineinragt, und in eine Aufbewahrungsposition bewegbar, in der ein Betätigungsabschnitt des Schiebers an einer dem Eingriffsabschnitt gegenüberliegenden Seite in die Gehäuseaussparung eingeschoben ist. In der Verriegelungsposition ragt der Betätigungsabschnitt des Schiebers aus der Gehäuseaussparung über das Gehäuse hinaus. Der Eingriffsabschnitt des Schiebers ragt in der Aufbewahrungsposition im Vergleich zur Verriegelungsposition noch weiter in die Gehäusenut und kann in der Verriegelungsposition in Eingriff mit einem korrespondieren Endabschnitt einer Hutschiene gebracht werden. Der Betätigungsabschnitt des Schiebers kann nur dann in die Gehäuseaussparung eingeschoben werden, wenn das Gerät nicht auf die Hutschiene gesteckt ist.

US 7 674 129 B1 betrifft eine Befestigungsvorrichtung für eine Hutschiene, die eine an einem Grundelement angeordnete Blattfeder und einen federbelasteten Schieber umfasst, der ein erstes und ein zweite Positionierelement umfasst und gegenüber dem Grundelement verschiebbar ist. Dabei ist die Blattfeder als Rastelement vom zweiten Positionierelement zum ersten Positionierelement beweglich und dort arretierbar, so dass die Befestigungsvorrichtung nicht ohne weiteres von der Hutschiene gelöst werden kann.

Aus WO 2008/068312 A1 ist eine Vorrichtung zur Befestigung eines Elektronikmoduls auf einer Tragschiene bekannt. Die Vorrichtung weist eine bewegliche Nase auf, die zusammen mit einer an einer Rückseite eines Gehäuses des Elektronikmoduls vorgesehenen festen Nase in montiertem Zustand ein Profil der Tragschiene umgreift. Die bewegliche Nase ist als Klemmprofil eines Schiebers ausgebildet, so dass die Vorrichtung mittels Einstecken von mechanischen Verankerungen in dafür vorgesehene Ausnehmungen des Gehäuses an der Rückseite des Elektronikmoduls montierbar ist. Außerdem weist die Vorrichtung einen Federmechanismus auf, der zur Abstützung am Gehäuse des Elektronikmoduls vorgesehen ist und durch den der Schieber mit einer Kraft beaufschlagt ist. Aus dieser Kraft resultiert eine Klemmkraft der Vorrichtung auf der Tragschiene. Darüber hinaus ragt ein der beweglichen Nase gegenüberliegendes Ende des Schiebers zur manuellen Verschiebung der beweglichen Nase über das Gehäuse des Elektronikmoduls hinaus.

In FR 2 727 804 A1 ist eine Vorrichtung entsprechend dem Oberbegriff von Patentanspruch 1 beschrieben, die zur Befestigung eines elektrischen Geräts an einer Hutschiene vorgesehen ist. Insbesondere umfasst diese Vorrichtung einen mit dem Gerät verbindbaren Grundkörper, der eine erste dem Gerät zugewandte Seite und eine zweite vom Gerät abgewandte Seite aufweist. Außerdem weist die Vorrichtung ein feststehendes erstes Fixierungselement an der zweiten Seite des Grundkörpers auf, das eine Nut oder eine Hinterschneidung aufweist, die in Eingriff mit einem abgekröpften Ende eines ersten Schenkels einer Hutschiene bringbar ist. Ein zweites Fixierungselement an der zweiten Seite des Grundkörpers ist in Richtung des ersten Fixierungselements verschiebbar. Das zweite Fixierungselement ist gegenüber dem ersten Fixierungselement mittels eines Federmechanismus vorgespannt und weist an einem ersten Ende eine Nut oder eine Hinterschneidung auf, die in Eingriff mit einem abgekröpften Ende eines zweiten Schenkels der Hutschiene bringbar ist. Dabei umgreifen das erste und das zweite Fixierungselement in einer Verriegelungsposition des zweiten Fixierungselements die abgekröpften Enden der Schenkel der Hutschiene im wesentlichen formschlüssig. Das zweite Fixierungselement ist zwischen der Verriegelungsposition und einer Montageposition verschiebbar. An einem zweiten Ende des zweiten Fixierungselements ist ein Begrenzungselement angeordnet, das sich quer zu einer Verschieberichtung des zweiten Fixierungselements erstreckt.

Unter rauhen Umgebungsbedingungen, beispielsweise unter Stoß- oder Vibrationseinwirkung, halten insbesondere Kommunikationsnetzkomponenten mit obigen Befestigungsvorrichtungen nicht gut auf TS-35-Hutschienen. Aus diesem Grund werden zu befestigende Geräte je nach Umgebungsbedingen auf einer Hutschiene festgeschraubt. Dies bedeutet einen zusätzlichen Montageaufwand.

Der vorliegenden Erfindung liegt daher die Aufgabe zugrunde, eine Vorrichtung zur einfachen und sicheren Befestigung eines Kommunikations- bzw. Automatisierungsgeräts an einer Hutschiene sowie ein geeignetes Kommunikations- bzw. Automatisierungsgerät zu schaffen.

Diese Aufgabe wird erfindungsgemäß durch eine Vorrichtung mit den in Patentanspruch 1 angegebenen Merkmalen sowie durch ein Kommunikations- bzw. Automatisierungsgerät mit den in Patentanspruch 11 angegebenen Merkmalen gelöst. Vorteilhafte Weiterbildungen der vorliegenden Erfindung sind in den abhängigen Patentansprüchen angegeben.

Die erfindungsgemäße Vorrichtung zur Befestigung eines Kommunikations- bzw. Automatisierungsgeräts an einer Hutschiene umfasst einen mit dem Kommunikations- bzw. Automatisierungsgerät verbindbaren Grundkörper, der eine erste dem Kommunikations- bzw. Automatisierungsgerät zugewandte Seite und eine zweite vom Kommunikations- bzw. Automatisierungsgerät abgewandte Seite aufweist. Der Grundkörper kann beispielsweise in ein Gehäuse des Kommunikations- bzw. Automatisierungsgeräts integriert ist. Des weiteren umfasst die Vorrichtung zumindest ein feststehendes erstes Fixierungselement an der zweiten Seite des Grundkörpers, das eine Nut oder eine Hinterschneidung aufweist, die in Eingriff mit einem abgekröpften Ende eines ersten Schenkels einer Hutschiene bringbar ist. Außerdem ist zumindest ein in Richtung des ersten Fixierungselements verschiebbares zweites Fixierungselement an der zweiten Seite des Grundkörpers vorgesehen. Das zweite Fixierungselement ist gegenüber dem ersten Fixierungselement mittels eines Federmechanismus vorgespannt und weist an einem ersten Ende eine Nut oder eine Hinterschneidung auf, die in Eingriff mit einem abgekröpften Ende eines zweiten Schenkels der Hutschiene bringbar ist. Dabei umgreifen das erste und das zweite Fixierungselement in einer Verriegelungsposition des zweiten Fixierungselements die abgekröpften Enden der Schenkel der Hutschiene im wesentlichen formschlüssig. Das zweite Fixierungselement ist zwischen der Verriegelungsposition und einer Montageposition verschiebbar. Der erste Schenkel einer Hutschiene kann in einem montierten Zustand der Hutschiene beispielsweise ein oberer Schenkel sein, während der zweite Schenkel im montierten Zustand der Hutschiene ein unterer Schenkel sein kann. Außerdem kann das zumindest eine erste Fixierungselement in diesem Fall hakenartig ausgestaltet sein.

Erfindungsgemäß ist an einem zweiten Ende des zweiten Fixierungselements ein Begrenzungselement angeordnet, das sich quer zu einer Verschieberichtung des zweiten Fixierungselements erstreckt und zwei entgegengesetzt zueinander geneigte Auflageflächen aufweist. Das Begrenzungselement kann beispielsweise als längliche Lippe mit trapez- oder dreieckförmigem Querschnitt ausgestaltet sein. Des weiteren ist eine Gewindebohrung durch einen an das zweite Ende des zweiten Fixierungselements angrenzenden Endabschnitt des Grundelements vorgesehen. Darüber hinaus ist von der ersten Seite des Grundelements eine Befestigungsschraube in die Gewindebohrung eingeschraubt. Dabei ist ein freies Ende der Befestigungsschraube in der Montageposition des zweiten Fixierungselements gegen eine erste Auflagefläche des Begrenzungselements und in der Verriegelungsposition des zweiten Fixierungselements gegen eine zweite Auflagefläche des Begrenzungselements verspannbar.

Mittels einer derartigen federbelasteten Schiebeverriegelung, die durch die Befestigungsschraube einfach und sicher von der ersten Seite des Grundkörpers verspannt werden kann, wird ein Kommunikations- bzw. Automatisierungsgerät unabhängig von einem jeweiligen Hutschienentyp fest mit einer Hutschiene verspannt. Die erfindungsgemäße Vorrichtung ist daher außerordentlich gut für eine Verwendung unter rauhen Umgebungsbedingen geeignet.

Entsprechend einer besonders bevorzugten Ausgestaltung der vorliegenden Erfindung weist die Befestigungsschraube an ihrem Schraubenkopf eine Rändelung auf. Somit ist eine werkzeuglose Benutzung einer derartigen Vorrichtung problemlos möglich. Darüber hinaus kann das Grundelement an der zweiten Seite zumindest zwei Führungselemente aufweisen, die das zweite Fixierungselement umgreifen. Somit wird das zweite Fixierungselement bei einer Verschiebung zwischen Verriegelungs- und Montageposition sicher geführt. Zusätzlich kann das Grundelement an der zweiten Seite einen Zapfen oder ein Befestigungsmittel aufweisen, der bzw. das in ein am zweiten Fixierungselement vorgesehenes Langloch eingreift. Dabei bildet der Zapfen oder das Befestigungsmittel einen Anschlag für eine Verschiebung des zweiten Fixierungselements zwischen der Montageposition und der Verriegelungsposition. Dies gewährleistet eine nochmals verbesserte Führung des zweiten Fixierungselements bei einer Verschiebung zwischen Verriegelungs- und Montageposition.

Am zweiten Ende des zweiten Fixierungselements ist entsprechend einer weiteren Ausgestaltung der vorliegenden Erfindung zumindest ein drittes Fixierungselement mit einer Nut oder einer Hinterschneidung vorgesehen, die in Eingriff mit einem Ende eines zweiten Schenkels eines weiteren Hutschienentyps bringbar ist. Dabei umgreifen das erste und das dritte Fixierungselement in einer Verriegelungsposition die Enden der Schenkel einer Hutschiene des weiteren Hutschienentyps im wesentlichen formschlüssig. Zusätzlich kann eine Mehrzahl zueinander beabstandeter erster Fixierungselemente an der zweiten Seite des Grundkörpers vorgesehen sein. Dabei sind die Nuten oder Hinterschneidungen der ersten Fixierungselemente in Eingriff mit einem Ende eines ersten Schenkels einer Hutschiene eines jeweils zugeordneten Hutschienentyps bringbar. Beispielsweise können angrenzend an jeweils gegenüberliegende Stirnseiten des Grundkörpers paarweise erste Fixierungselemente an der zweiten Seite des Grundkörpers angeordnet sein. Insgesamt ist damit eine universelle Vorrichtung zur Befestigung eines Kommunikations- bzw. Automatisierungsgerät an einer Vielzahl unterschiedlicher Hutschienentypen geschaffen.

Das erfindungsgemäße Kommunikations- bzw. Automatisierungsgerät umfasst ein Gehäuse, in das eine Vorrichtung entsprechend vorangehenden Ausführungen integriert ist.

Die vorliegende Erfindung wird nachfolgend an einem Ausführungsbeispiel anhand der Zeichnung näher erläutert. Es zeigt
- Figur 1: eine rückseitige perspektivische Darstellung von zwei Vorrichtungen zur Befestigung eines Kommunikations- bzw. Automatisierungsgeräts an einer Hutschiene,
- Figur 2: eine vorderseitige Darstellung einer ersten Vorrichtung gemäß Figur 1,
- Figur 3: einen Schnittdarstellung der Vorrichtung gemäß Figur 2 in Verbindung mit einer Hutschienenanordnung,
- Figur 4: eine vorderseitige Darstellung einer zweiten Vorrichtung gemäß Figur 1,
- Figur 5: einen Schnittdarstellung der Vorrichtung gemäß Figur 4 in Verbindung mit einer Hutschienenanordnung.

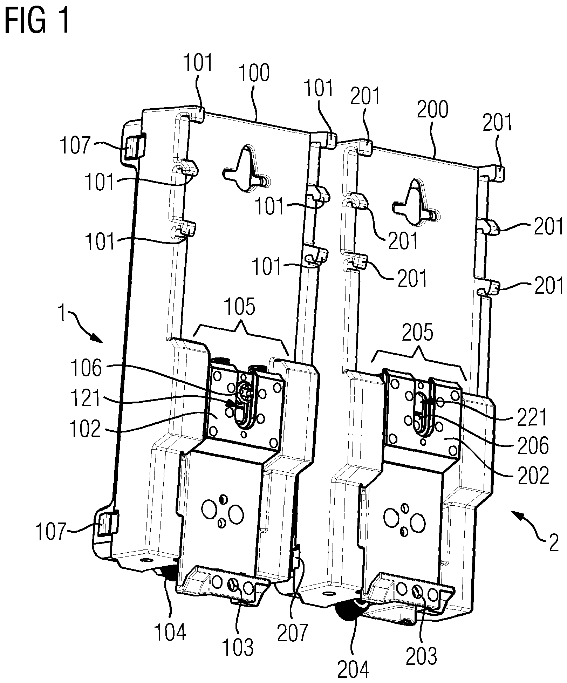

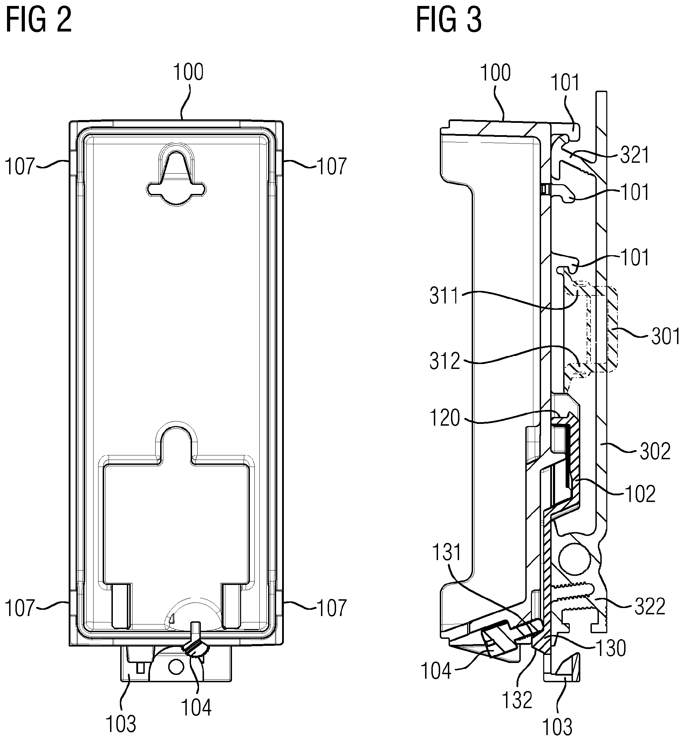

Die in Figur 1 dargestellten Vorrichtungen 1, 2 zur Befestigung eines Kommunikations- bzw. Automatisierungsgeräts an einer Hutschiene umfassen jeweils einen mit dem Kommunikations- bzw. Automatisierungsgerät verbindbaren Grundkörper 100, 200, der eine dem Kommunikations- bzw. Automatisierungsgerät zugewandte Vorderseite und eine vom Kommunikations- bzw. Automatisierungsgerät abgewandte Rückseite aufweist. Der jeweilige Grundkörper 100, 200 kann beispielsweise auch in ein Gehäuse des Kommunikations- bzw. Automatisierungsgeräts integriert sein. Im vorliegenden Ausführungsbeispiel umfassen die Grundkörper 100, 200 an ihrer Vorderseite mehrere Rastelemente 107, 207 (siehe auch Figur 2 und 3) zur Verrastung des Gehäuses eines Kommunikations- bzw. Automatisierungsgeräts am jeweiligen Grundkörper 100, 200.

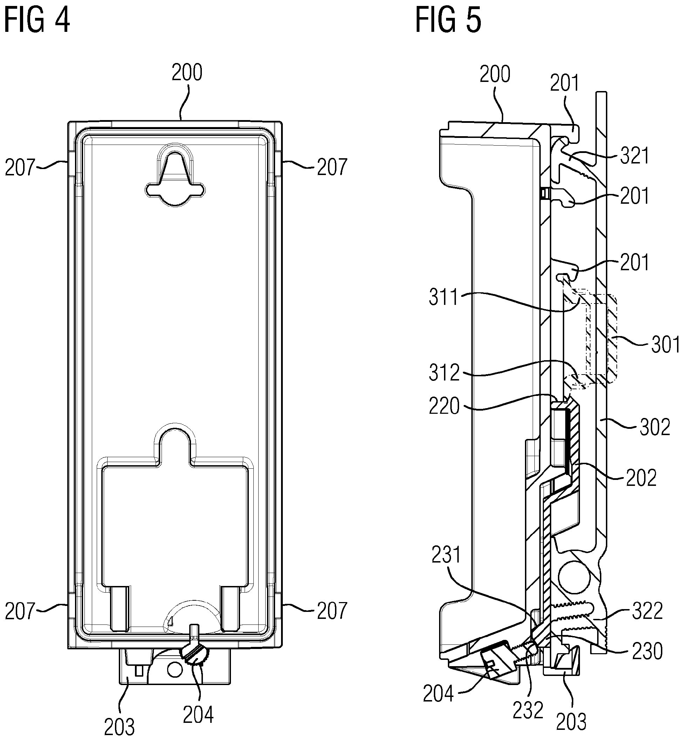

An der Rückseite des jeweiligen Grundkörpers 100, 200 ist eine Mehrzahl zueinander beabstandeter erster oberer Fixierungselemente 101, 201 vorgesehen, deren hakenartig ausgestaltete Nuten oder Hinterschneidungen in Eingriff mit einem Ende eines ersten oberen Schenkels 311, 321 einer Hutschiene 301, 302 eines jeweils zugeordneten Hutschienentyps bringbar sind (siehe Figur 3 und 5). Im vorliegenden Ausführungsbeispiel ist eine Hutschienenanordnung dargestellt, die eine TS-35-Hutschiene 301 und eine SIMATIC-S7-Profilschiene 302 umfasst. Die TS-35-Hutschiene 301 weist an ihren Schenkelenden Abkröpfungen auf, während die SIMATIC-S7-Profilschiene 302 an ihrem zweiten unteren Schenkel 322 eine Nut aufweist. Die ersten Fixierungselemente 101, 201 sind angrenzend an jeweils gegenüberliegende Stirnseiten des jeweiligen Grundkörpers 100, 200 paarweise angeordnet.

An der Rückseite des jeweiligen Grundkörpers 100, 200 ist außerdem ein in Richtung der ersten oberen Fixierungselemente 101, 201 verschiebbares zweiten unteres Fixierungselement 102, 202 vorgesehen, das als Schieber ausgestaltet ist. Das jeweilige zweite untere Fixierungselement 102, 202 ist gegenüber den ersten oberen Fixierungselementen 101, 201 mittels eines Federmechanismus vorgespannt und weist an einem ersten Ende eine Nut oder eine Hinterschneidung 120, 220 auf. Diese Nut bzw. Hinterschneidung 120, 220 ist in Eingriff mit einem abgekröpften Ende eines zweiten unteren Schenkels 312 der TS-35-Hutschiene 301 bringbar. Dabei umgreifen die ersten oberen 101, 201 und die zweiten unteren Fixierungselemente 102, 202 in einer Verriegelungsposition des jeweiligen zweiten unteren Fixierungselements 102, 202 die abgekröpften Enden der Schenkel 311, 312 der TS-35-Hutschiene im wesentlichen formschlüssig. Dabei ist das jeweilige zweite untere Fixierungselement 102, 202 zwischen der Verriegelungsposition und einer Montageposition verschiebbar. Entsprechend Figur 1 ist eine erste Vorrichtung 1 mit einem zweiten unteren Fixierungselement 102 in Montageposition dargestellt, während eine zweite Vorrichtung 2 mit einem zweiten unteren Fixierungselement in Verriegelungsposition dargestellt ist. Vorderansicht und Schnittdarstellung der ersten Vorrichtung 1 sind Figur 2 und 3 zu entnehmen, während Vorderansicht und Schnittdarstellung der zweiten Vorrichtung 2 sind Figur 4 und 5 zu entnehmen sind.

Die Grundelemente 100, 200 weisen an ihrer Rückseite jeweils zwei integrierte Führungselemente 105, 205 auf, die das jeweilige zweite untere Fixierungselement 102, 2002 umgreifen. Zusätzlich weisen die Grundelemente 100, 200 an ihrer Rückseite jeweils eine Führungsschraube 106, 206 auf, deren Schaft in ein am jeweiligen zweiten unteren Fixierungselement 102, 202 vorgesehenes Langloch 121, 221 eingreift. Dabei bildet die jeweilige Führungsschraube 106, 206 einen Anschlag für eine Verschiebung des jeweiligen zweiten unteren Fixierungselements 102, 202 zwischen der Montageposition und der Verriegelungsposition. Anstelle mittels einer Führungsschraube 106, 206 kann ein solcher Anschlag beispielsweise auch mittels eines Zapfens oder eines sonstigen Befestigungsmittels am jeweiligen Grundkörper 100, 200 gebildet werden.

Entsprechend Figur 3 und 5 ist an einem zweiten Ende des jeweiligen zweiten unteren Fixierungselements 102, 202 jeweils ein Begrenzungselement 130, 230 angeordnet, das als längliche Lippe mit trapez- oder dreieckförmigem Querschnitt ausgestaltet ist. Darüber hinaus erstrecken sich die Begrenzungselemente 130, 230 quer zu einer Verschieberichtung des jeweiligen zweiten unteren Fixierungselements 102, 202 erstreckt und weisen jeweils zwei entgegengesetzt zueinander geneigte Auflageflächen 131-132, 231-232 auf. Des weiteren weisen die Grundelemente 100, 200 jeweils eine Gewindebohrung durch einen an das zweite Ende des jeweiligen zweiten unteren Fixierungselements 102, 202 angrenzenden Endabschnitt auf. Von der Vorderseite des jeweiligen Grundelements 100, 200 ist jeweils eine Befestigungsschraube 104, 204 in die zugeordnete Gewindebohrung eingeschraubt. Dabei ist ein freies Ende einer Befestigungsschraube 104, 204 in der Montageposition des jeweiligen zweiten unteren Fixierungselements 102, 202 gegen eine erste Auflagefläche 131, 231 des zugeordneten Begrenzungselements 130, 230 und in der Verriegelungsposition des jeweiligen zweiten unteren Fixierungselements 102, 202 gegen eine zweite Auflagefläche 132, 232 des zugeordneten Begrenzungselements 130, 230 verspannbar. Zur werkzeuglosen Betätigung weisen die Befestigungsschrauben 104, 204 jeweils an ihrem Schraubenkopf eine Rändelung auf.

Neben den zweiten unteren Fixierungselementen 102, 202 für die TS-35-Hutschiene 301 umfassen die Grundkörper 100, 200 jeweils dritte untere Fixierungselemente 103, 203 für die SIMATIC-S7-Profilschiene 302. Die dritten unteren Fixierungselemente 103, 203 sind jeweils am zweiten Ende des jeweiligen zweiten unteren Fixierungselements 102, 202 vorgesehen und weisen jeweils eine Nut oder Hinterschneidung auf, die in Eingriff mit einer Nut an einem Ende des zweiten unteren Schenkels 322 der SIMATIC-S7-Profilschiene 302 bringbar ist. Dabei umgreifen die ersten oberen 101, 201 und die dritte unteren Fixierungselemente 103, 203 in der Verriegelungsposition im wesentlichen formschlüssig die Enden der Schenkel 321, 322 der SIMATIC-S7-Profilschiene 302.

## Patentansprüche

1. Vorrichtung zur Befestigung eines Kommunikations- und/oder Automatisierungsgeräts an einer Hutschiene mit
- einem mit dem Kommunikations- und/oder Automatisierungsgerät verbindbaren Grundkörper (100, 200), der eine erste dem Kommunikations- und/oder Automatisierungsgerät zugewandte Seite und eine zweite vom Kommunikationsund/oder Automatisierungsgerät abgewandte Seite aufweist,
- zumindest einem feststehenden ersten Fixierungselement (101, 201) an der zweiten Seite des Grundkörpers (100, 200), das eine Nut oder eine Hinterschneidung aufweist, die in Eingriff mit einem abgekröpften Ende eines ersten Schenkels (311) einer Hutschiene (301) bringbar ist,
- zumindest einem in Richtung des ersten Fixierungselements verschiebbaren zweiten Fixierungselement (102, 202) an der zweiten Seite des Grundkörpers (100, 200), das gegenüber dem ersten Fixierungselement(101, 201) mittels eines Federmechanismus vorgespannt ist und an einem ersten Ende eine Nut oder eine Hinterschneidung (120, 220) aufweist, die in Eingriff mit einem abgekröpften Ende eines zweiten Schenkels (312) der Hutschiene (301) bringbar ist, wobei das erste (101, 201) und das zweite Fixierungselement (102, 202) in einer Verriegelungsposition des zweiten Fixierungselements (102, 202) die abgekröpften Enden der Schenkel (311, 312) der Hutschiene (301) im wesentlichen formschlüssig umgreifen, und wobei das zweite Fixierungselement (102, 202) zwischen der Verriegelungsposition und einer Montageposition verschiebbar ist,
- einem an einem zweiten Ende des zweiten Fixierungselements (102, 202) angeordneten Begrenzungselement (130, 230), das sich quer zu einer Verschieberichtung des zweiten Fixierungselements (102, 202) erstreckt,
**dadurch gekennzeichnet, dass**
- das Begrenzungselement (130, 230) zwei entgegengesetzt zueinander geneigte Auflageflächen (131-132, 231-232) aufweist,
- eine Gewindebohrung durch einen an das zweite Ende des zweiten Fixierungselements (102, 202) angrenzenden Endabschnitt des Grundelements (100, 200) vorgesehen ist,
- eine Befestigungsschraube (104, 204) von der ersten Seite des Grundelements (100, 200) in die Gewindebohrung eingeschraubt ist, wobei ein freies Ende der Befestigungsschraube (104, 204) in der Montageposition des zweiten Fixierungselements (102, 202) gegen eine erste Auflagefläche (131, 231) des Begrenzungselements (130, 230) und in der Verriegelungsposition des zweiten Fixierungselements (102, 202) gegen eine zweite Auflagefläche (132, 232) des Begrenzungselements verspannbar ist.

2. Vorrichtung nach Anspruch 1,
bei der die Befestigungsschraube (104, 204) an ihrem Schraubenkopf eine Rändelung aufweist.

3. Vorrichtung nach einem der Ansprüche 1 oder 2,
bei der das Begrenzungselement (130, 230) als längliche Lippe mit trapez- oder dreieckförmigem Querschnitt ausgestaltet ist.

4. Vorrichtung nach einem der Ansprüche 1 bis 3,
bei der das Grundelement (100, 200) an der zweiten Seite zumindest zwei Führungselemente (105, 205) aufweist, die das zweite Fixierungselement (102, 202) umgreifen.

5. Vorrichtung nach einem der Ansprüche 1 bis 4,
bei der das Grundelement (100, 200) an der zweiten Seite einen Zapfen oder ein Befestigungsmittel (106, 206) aufweist, der/das in ein am zweiten Fixierungselement (102, 202) vorgesehenes Langloch (121, 221) eingreift, wobei der Zapfen oder das Befestigungsmittel (106, 206) einen Anschlag für eine Verschiebung des zweiten Fixierungselements (102, 202) zwischen der Montageposition und der Verriegelungsposition bildet.

6. Vorrichtung nach einem der Ansprüche 1 bis 5,
bei dem am zweiten Ende des zweiten Fixierungselements (102, 202) zumindest ein drittes Fixierungselement (103, 203) mit einer Nut oder einer Hinterschneidung vorgesehen ist, die in Eingriff mit einem Ende eines zweiten Schenkels (322) eines weiteren Hutschienentyps bringbar ist, wobei das erste (101, 201) und das dritte Fixierungselement (103, 203) in einer Verriegelungsposition die Enden der Schenkel (321, 322) einer Hutschiene (302) des weiteren Hutschienentyps im wesentlichen formschlüssig umgreifen.

7. Vorrichtung nach einem der Ansprüche 1 bis 6,
bei dem eine Mehrzahl zueinander beabstandeter erster Fixierungselemente (101, 201) an der zweiten Seite des Grundkörpers (100, 200) vorgesehen ist, deren Nuten oder Hinterschneidungen in Eingriff mit einem Ende eines ersten Schenkels (311, 321) einer Hutschiene eines jeweils zugeordneten Hutschienentyps bringbar sind.

8. Vorrichtung nach einem der Ansprüche 1 bis 7,
bei dem angrenzend an jeweils gegenüberliegende Stirnseiten des Grundkörpers (100, 200) paarweise erste Fixierungselemente (101, 201) an der zweiten Seite des Grundkörpers angeordnet sind.

9. Vorrichtung nach einem der Ansprüche 1 bis 8,
bei dem der erste Schenkel (311, 321) einer Hutschiene (301, 302) in einem montierten Zustand der Hutschiene (301, 302) ein oberer Schenkel ist, und bei dem der zweite Schenkel (312, 322) im montierten Zustand der Hutschiene (301, 302) ein unterer Schenkel ist, und bei dem das zumindest eine erste Fixierungselement (101, 201) hakenartig ausgestaltet ist.

10. Vorrichtung nach einem der Ansprüche 1 bis 9,
bei dem der Grundkörper (10, 200) in ein Gehäuse des Kommunikations- und/oder Automatisierungsgeräts integriert ist.

11. Kommunikations- und/oder Automatisierungsgerät mit einem Gehäuse, in das eine Vorrichtung nach einem der Ansprüche 1-10 integriert ist.

## Claims

1. Apparatus for fastening a communication and/or automation device to a top-hat rail, comprising
- a main body (100, 200) which can be connected to the communication and/or automation device and has a first side, which faces the communication and/or automation device, and a second side, which is averted from the communication and/or automation device,
- at least one stationary first fixing element (101, 201) on the second side of the main body (100, 200), which first fixing element has a groove or an undercut which can be brought into engagement with a bent end of a first limb (311) of a top-hat rail (301),
- at least one second fixing element (102, 202) on the second side of the main body (100, 200), which second fixing element can be displaced in the direction of the first fixing element and is pretensioned in relation to the first fixing element (101, 201) by means of a spring mechanism and has a groove or an undercut (120, 220) at a first end, which groove or undercut can be brought into engagement with a bent end of a second limb (312) of the top-hat rail (301), wherein the first fixing element (101, 201) and the second fixing element (102, 202), in a locking position of the second fixing element (102, 202), engage in a substantially interlocking manner around the bent ends of the limbs (311, 312) of the top-hat rail (301), and wherein the second fixing element (102, 202) can be displaced between the locking position and a mounting position,
- a delimiting element (130, 230) which is arranged at a second end of the second fixing element (102, 202) and extends transversely in relation to a displacement direction of the second fixing element (102, 202),
**characterized in that**
- the delimiting element (130, 230) has two support faces (131-132, 231-232) which are inclined oppositely in relation to one another,
- a threaded bore is provided through an end section of the main element (100, 200), which end section adjoins the second end of the second fixing element (102, 202),
- a fastening screw (104, 204) is screwed into the threaded bore from the first side of the main element (100, 200), wherein a free end of the fastening screw (104, 204) can be clamped against a first support face (131, 231) of the delimiting element (130, 230) in the mounting position of the second fixing element (102, 202) and can be clamped against a second support face (132, 232) of the delimiting element in the locking position of the second fixing element (102, 202).

2. Apparatus according to Claim 1,
in which the fastening screw (104, 204) has a knurling at its screw head.

3. Apparatus according to either of Claims 1 and 2,
in which the delimiting element (130, 230) is configured as an elongate lip with a trapezoidal or triangular cross section.

4. Apparatus according to one of Claims 1 to 3,
in which the main element (100, 200) has at least two guide elements (105, 205) on the second side, which at least two guide elements engage around the second fixing element (102, 202) .

5. Apparatus according to one of Claims 1 to 4,
in which the main element (100, 200) has a pin or a fastening means (106, 206) on the second side, which pin/fastening means engages into an elongate hole (121, 221) which is provided on the second fixing element (102, 202), wherein the pin or the fastening means (106, 206) forms a stop for a displacement of the second fixing element (102, 202) between the mounting position and the locking position.

6. Apparatus according to one of Claims 1 to 5,
in which at least one third fixing element (103, 203) with a groove or an undercut is provided at the second end of the second fixing element (102, 202), which groove or undercut can be brought into engagement with an end of a second limb (322) of a further top-hat rail type, wherein the first fixing element (101, 201) and the third fixing element (103, 203) engage in a substantially interlocking manner around the ends of the limbs (321, 322) of a top-hat rail (302) of the further top-hat rail type in a locking position.

7. Apparatus according to one of Claims 1 to 6,
in which a plurality of first fixing elements (101, 201) which are at a distance from one another is provided on the second side of the main body (100, 200), it being possible to bring the grooves or undercuts of the said first fixing elements into engagement with an end of a first limb (311, 321) of a top-hat rail of a respectively associated top-hat rail type.

8. Apparatus according to one of Claims 1 to 7,
in which first fixing elements (101, 201) are arranged on the second side of the main body in a manner adjoining in each case opposite end sides of the main body (100, 200) in pairs.

9. Apparatus according to one of Claims 1 to 8,
in which the first limb (311, 321) of a top-hat rail (301, 302), in a mounted state of the top-hat rail (301, 302), is an upper limb, and in which the second limb (312, 322), in the mounted state of the top-hat rail (301, 302), is a lower limb, and in which the at least one first fixing element (101, 201) is configured in the manner of a hook.

10. Apparatus according to one of Claims 1 to 9,
in which the main body (100, 200) is integrated into a housing of the communication and/or automation device.

11. Communication and/or automation device comprising a housing into which an apparatus according to one of Claims 1 to 10 is integrated.

## Revendications

1. Dispositif de fixation d'un appareil de communication et/ou d'automatisation sur un profilé chapeau, comprenant
- une pièce (100) de base, qui peut être assemblée à l'appareil de communication et/ou d'automatisation et qui a un premier côté tourné vers l'appareil de communication et/ou d'automatisation et un deuxième côté éloigné de l'appareil de communication et/ou d'automatisation,
- au moins un premier élément (101, 201) d'immobilisation fixe sur le deuxième côté de la pièce (100, 200) de base, qui a une rainure ou une contre-dépouille pouvant être mise en prise avec une extrémité coudée d'une première branche (311) d'un profilé (301) chapeau,
- au moins un deuxième élément (102) d'immobilisation, pouvant coulisser en direction du premier élément d'immobilisation, sur le deuxième côté de la pièce (100, 200) de base, qui est précontraint, par rapport au premier élément (101, 201) d'immobilisation, au moyen d'un mécanisme à ressort et qui a, à une première extrémité, une rainure ou une contre-dépouille (120, 220), qui peut être mise en prise avec une extrémité coudée d'une deuxième branche (312) du profilé (301) chapeau, le premier (101, 201) et le deuxième 102, 202) éléments d'immobilisation prenant, sensiblement à complémentarité de forme, dans une position de verrouillage du deuxième élément (102, 202) d'immobilisation, les extrémités coudées des branches (311, 312) du profilé (301) chapeau et le deuxième élément (102, 202) d'immobilisation pouvant coulisser entre la position de verrouillage et une position de montage,
- un élément (130, 230) de limitation, qui est disposé à une deuxième extrémité du deuxième élément (102, 202) d'immobilisation et qui s'étend transversalement à une direction de coulissement du deuxième élément (102, 202) d'immobilisation,
**caractérisé en ce que**
- l'élément (130, 230) de limitation a deux surfaces (131-132, 231-232) d'appui inclinées l'une par rapport à l'autre de manière opposée,
- il est prévu un taraudage dans une partie d'extrémité, voisine de la deuxième extrémité du deuxième élément (102, 202) d'immobilisation, de la pièce (100, 200) de base,
- une vis (104, 204) de fixation est vissée dans le taraudage par le premier côté de la pièce (100, 200) de base, une extrémité libre de la vis (104, 204) de fixation pouvant, dans la position de montage du deuxième élément (102, 202) d'immobilisation, être serrée sur une première surface (131, 231) d'appui de l'élément (130, 230) de limitation et, dans la position de verrouillage du deuxième élément (102, 202) d'immobilisation, sur une deuxième surface (132, 232) d'appui de l'élément de limitation.

2. Dispositif suivant la revendication 1,
dans lequel la vis (104, 204) de fixation a un moletage sur sa tête de vis.

3. Dispositif suivant la revendication 1 ou 2,
dans lequel l'élément (130, 230) de limitation est conformée sous la forme d'une lèvre oblongue de section transversale trapézoïdale ou triangulaire.

4. Dispositif suivant l'une des revendications 1 à 3,
dans lequel la pièce (100, 200) de base a, du deuxième côté, au moins deux éléments (105, 205) de guidage, qui prennent le deuxième élément (102, 202) d'immobilisation.

5. Dispositif suivant l'une des revendications 1 à 4,
dans lequel la pièce (100, 200) de base a, du deuxième côté, un tenon ou un moyen (106, 206) de fixation, qui pénètre dans une boutonnière (121, 221) prévue sur le deuxième élément (102, 202) d'immobilisation, le tenon ou le moyen (106, 206) de fixation formant une butée pour un coulissement du deuxième (102, 202) d'immobilisation entre la position de montage et la position de verrouillage.

6. Dispositif suivant l'une des revendications 1 à 5,
dans lequel, à la deuxième extrémité du deuxième élément (102, 202) d'immobilisation, est prévu un troisième élément (103, 203) d'immobilisation ayant une rainure ou une contre-dépouille, qui peut être mise en prise avec une extrémité d'une deuxième branche (322) d'un autre type de profilé chapeau, le premier (101, 201) et le troisième (103, 203) éléments d'immobilisation prenant, sensiblement à complémentarité de forme, dans une position de verrouillage, les extrémités des branches (321, 322) d'un profilé (302) chapeau de l'autre type de profilé chapeau.

7. Dispositif suivant l'une des revendications 1 à 6,
dans lequel il est prévu une pluralité de premiers éléments (101, 201) d'immobilisation à distance les unes des autres du deuxième côté de la pièce (100, 200) de base, dont les rainures ou les contre-dépouilles peuvent être mises en prise avec une extrémité d'une première branche (311, 321) d'un profilé chapeau, d'un type de profilé chapeau associé respectivement.

8. Dispositif suivant l'une des revendications 1 à 7,
dans lequel, au voisinage de côtés frontaux opposés de la pièce (100, 200) de base, des premiers éléments (101, 201) d'immobilisation sont disposés par paire du deuxième côté de la pièce de base.

9. Dispositif suivant l'une des revendications 1 à 8,
dans lequel la première branche (311, 321) d'un profilé (301, 302) chapeau est, alors que le profilé (301, 302) chapeau est à l'état monté, une branche supérieure et dans lequel la deuxième branche (312, 322), alors que le profilé (301, 302) chapeau est à l'état monté, est une branche inférieure et dans lequel le au moins un premier élément (101, 201) d'immobilisation est conformé en crochet.

10. Dispositif suivant l'une des revendications 1 à 9,
dans lequel la pièce (100, 200) de base est intégrée dans un boîtier de l'appareil de communication et/ou d'automatisation.

11. Appareil de communication et/ou d'automatisation ayant un boîtier, dans lequel est intégré un dispositif suivant l'une des revendications 1 à 10.
